(19) Europäisches Patentamt
European Patent Office
Office européen des brevets

(11) **EP 1 908 860 A1**

(12) **EUROPEAN PATENT APPLICATION**
published in accordance with Art. 153(4) EPC

(43) Date of publication:
**09.04.2008 Bulletin 2008/15**

(51) Int Cl.:
**C30B 7/10** (2006.01)   **C30B 29/16** (2006.01)
**C30B 29/18** (2006.01)   **C30B 29/38** (2006.01)

(21) Application number: **06767573.6**

(22) Date of filing: **29.06.2006**

(86) International application number:
**PCT/JP2006/312956**

(87) International publication number:
**WO 2007/004495 (11.01.2007 Gazette 2007/02)**

(84) Designated Contracting States:
**DE PL**

(30) Priority: **01.07.2005 JP 2005194032**

(71) Applicants:
• **Mitsubishi Chemical Corporation**
  **Minato-ku**
  **Tokyo 108-0014 (JP)**
• **TOHOKU UNIVERSITY**
  **Sendai, Miyagi 980-8577 (JP)**

(72) Inventors:
• **KAWABATA, Shinichiro**
  **MITSUBISHI CHEMICAL CORPORATION**
  **Ushiku-shi, Ibaraki 300-1295 (JP)**

• **YOSHIKAWA, Akira**
  **Sendai-shi, Miyagi 980-8577 (JP)**
• **KAGAMITANI, Yuji**
  **Sendai-shi, Miyagi 980-8577 (JP)**
• **FUKUDA, Tsuguo**
  **Sendai-shi, Miyagi 980-8577 (JP)**

(74) Representative: **Naylor, Matthew John**
  **Mewburn Ellis LLP**
  **York House,**
  **23 Kingsway**
  **London WC2B 6HP (GB)**

(54) **PROCESS FOR PRODUCING CRYSTAL WITH SUPERCRTICAL SOLVENT, CRYSTAL GROWTH APPARATUS, CRYSTAL, AND DEVICE**

(57)    To control the precipitation position of a crystal and increase the yield of the crystal by performing the crystal growth according to the solvothermal method while allowing a predetermined amount of a substance differing in the critical density from the solvent to be present in the reaction vessel; and to prevent mixing of an impurity into the crystal and improve the crystal purity.

Fig.1

**Description**

TECHNICAL FIELD

The present invention relates to a process for producing a crystal by a solvothermal method. More specifically, the present invention relates to a process and an apparatus for producing a high-quality bulk crystal by a hydrothermal method of performing the crystal growth of, for example, rock crystal or zinc oxide (hereinafter, "ZnO" which is the chemical formula of zinc oxide is used as the term having the same meaning) by using water as the solvent or an ammonothermal method of performing the crystal growth of, for example, a nitride of a Periodic Table Group 13 element (hereinafter referred to as a "Group 13 element"), as represented by gallium nitride (hereinafter "GaN" which is the chemical formula of gallium nitride is used as the term having the same meaning), by using a nitrogen-containing solvent such as ammonia.

BACKGROUND ART

The solvothermal method is a generic term of crystal production methods using a solvent in the supercritical state and is called a hydrothermal method or an ammonothermal method depending on the kind of the solvent used. According to the solvothermal method, a temperature difference is created in a high-temperature high-pressure system and by utilizing a solubility difference of crystal in a solvent attributable to the temperature difference, the crystal growth is performed.

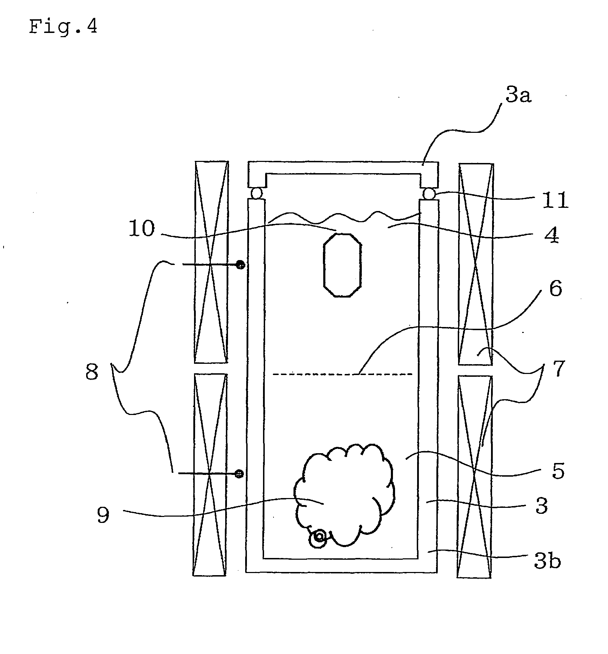

Fig. 4 shows a schematic view of a crystal production apparatus according to a solvothermal method. Reference numeral 3 denotes an autoclave, reference numeral 3a denotes a cover material, reference numeral 3b denotes a reactor body, reference numeral 4 denotes a crystal growth part, reference numeral 5 denotes a raw material filling part, reference numeral 6 denotes a baffle plate, reference numeral 7 denotes an electric furnace, reference numeral 8 denotes a thermocouple, reference numeral 9 denotes a raw material, reference numeral 10 denotes a seed crystal, and reference numeral 11 denotes a gasket or a packing (hereinafter referred to as a "gasket or the like").

In order to create a temperature difference in a high-temperature high-pressure system, the electric furnace 7 is divided into a plurality of zones (in Fig. 4, divided into two zones), and the output is changed among zones. In the case where the solubility curve has a positive gradient (as the temperature arises, the solubility increases), the temperature difference is set such that the temperature becomes lower toward the upper side of the autoclave 3.

In this case, the convection of the solvent, that is, the transport flow for the solute such as crystal raw material, enters a lower temperature region as climes up the autoclave 3. Also, the top and bottom neighborhoods of the autoclave 3 are, unlike the side surface, not directly heated by the electric furnace, and the heat readily escapes therefrom to lower the temperature. In such a low temperature part, the crystal raw material or the like in the supersaturated state disadvantageously precipitates as a deposit not only on the seed crystal 10 but also on the holding member (not shown) for fixing the seed crystal or on the inner wall of the autoclave 3.

Conventionally, a heat insulating material or the like is disposed outside the upper and lower parts of the autoclave so as to prevent precipitation of the crystal raw material or the like, or a structure allowing for less escape of heat from the upper and lower parts of the autoclave is constructed by disposing an auxiliary heater or increasing the size of the electric furnace as compared with the autoclave with an attempt to prevent precipitation of the crystal or the like.

Furthermore, a deposit collecting net is provided above the seed crystal in the autoclave or near the convergence point of the solvent convection, so that after the residual crystal raw material not precipitated on the seed crystal is inverted downward by the top inner wall, the fine crystal or deposit in the transport flow can be captured by the collecting net or the fine crystal can be selectively precipitated on the collecting net, thereby preventing precipitation on the holding member for fixing the seed crystal or on the inner wall of the autoclave (see Patent Reference 1 and Patent Reference 2).

However, the technique of disposing a heat insulating material or improving the electric furnace incurs a problem that the crystal production apparatus is large-sized or complicated, and the technique of providing a collecting net or the like is disadvantageous in that the precipitation on the portion other than the objective crystal growth position such as seed crystal leads to decrease in the yield of the grown crystal.

The crystal grown by the solvothermal method is used in the field of electronics, optics or the like. For example, the rock crystal is used for a quartz oscillator, a quartz filter or a surface acoustic wave (SAW) device, and the zinc oxide is used in various fields such as blue-violet or ultraviolet light-emitting device (or substrate therefor), surface acoustic wave (SAW) device, gas sensor, piezoelectric element, transparent electrically conducting material and varistor.

Also, the Group 13 element nitride as represented by gallium nitride is useful as a material applied to an electronic device such as light-emitting diode and laser diode. The electronic device is produced at present by a method of growing the crystal on a substrate such as sapphire or silicon carbide by the vapor-phase epitaxial growth such as MOCVD (Metal-Organic Chemical Vapor Deposition) process.

However, this method has a problem that since a GaN crystal is heteroepitaxially grown on a substrate differing in the lattice constant and thermal expansion coefficient from GaN, a dislocation or a lattice defect is readily generated in the obtained GaN crystal and the quality applicable to a blue laser or the like can be hardly obtained. In recent years, a high-quality gallium nitride bulk single crystal for a homoepitaxial substrate taking the place of the above-described substrate is expected.

On the other hand, in the hydrothermal method, the solvent is water but since an alkali such as sodium hydroxide (NaOH) and potassium hydroxide (KOH) or an acid such as phosphoric acid ($H_3PO_4$) is dissolved as the mineralizer, an alkaline or acidic aqueous solution is formed. In the ammonothermal method, the solvent is ammonia or the like. The autoclave is eroded by the alkali solution, acid solution, ammonia or the like, as a result, an impurity contained in the autoclave is mixed into the obtained crystal and the crystal quality disadvantageously deteriorates.

The produced crystal is used in the field of electronics, optics or the like and therefore, the quality deterioration due to mixing of an impurity affects the yield of the product. Particularly, in usage as a semiconductor substrate, it is necessary to grow a high-purity crystal by preventing mixing of a transition metal component or the like giving increase in number of lattice defects, increase in the dislocation density, or formation of an impurity state in the bandgap.

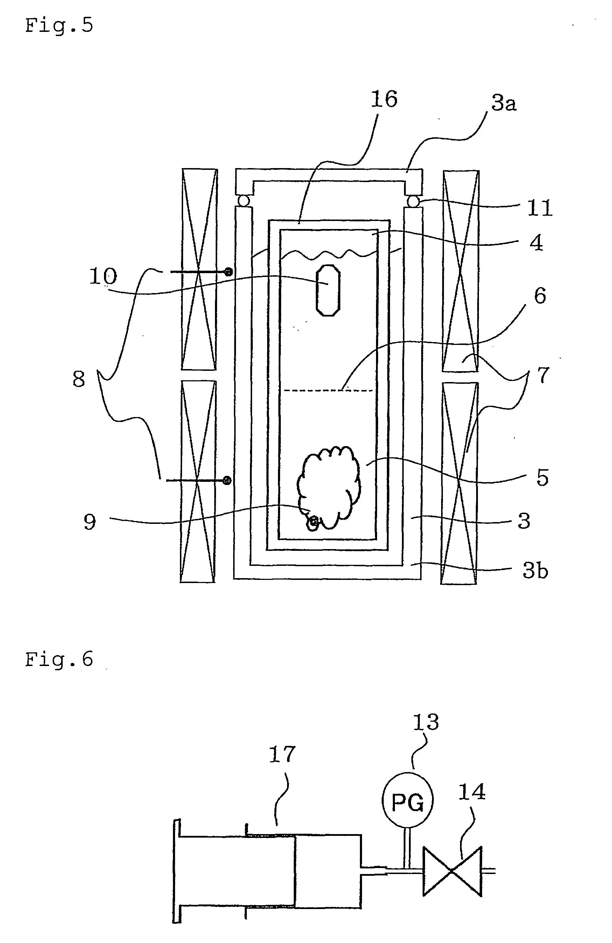

Conventionally, in order to prevent erosion of the autoclave, the mixing of an impurity is prevented by constructing the inner surface of the autoclave to have a noble metal coat or noble metal liner structure (see Non-Patent Reference 1, Patent Reference 2 and Patent Reference 3), or the mixing of an impurity is prevented by constructing a double structure where, as shown in Fig. 5, a noble metal-made container indicated by reference numeral 16 is separately used in the autoclave 3 (see Patent Reference 4).

The autoclave or container is sealed by using a gasket or the like between the cover material and the reactor body or by welding. In the case of welding, the welding operation takes time and moreover, it is difficult to apply a noble metal coat or the like to the entire inner surface or recycle the used container. In the case of sealing with use of a gasket or the like, the gasket or the like must be also made of a noble metal or coated with a noble metal and this causes a problem that the cost rises.

Furthermore, in the ammonothermal method, unlike the hydrothermal method, an ammonia solvent which becomes a gas at ordinary temperature and atmospheric pressure is used and therefore, the production apparatus sometimes has an attached inlet tube such as valve for filling/discharging the ammonia solvent at the upper or lower part of the autoclave. According to the studies by the present inventors, it is found that after the completion of crystal growth, the crystal or mineralizer precipitates on such an inlet tube to cause a trouble in the discharge of the ammonia solvent and the system is industrially cumbersome.

Also, the precipitation of crystal in the inlet tube reveals that the inside of the inlet tube has come into contact with ammonia which is a supercritical solvent, and this suggests that the inlet tube or the like is exposed to the supercritical-state ammonia of high erosive and provides a source for the mixing of an impurity. The autoclave body can cope with the high erosive by applying an erosion-resistant material such as noble metal to construct the above-described liner structure or the like, but the construction of a liner structure by applying a noble metal or the like even to the inside of inlet tube and valve is very difficult and disadvantageously incurs a high cost.

[Patent Reference 1]: JP-A-2004-315361
[Patent Reference 2]: JP-A-2004-2152
[Patent Reference 3]: JP-A-2003-165794
[Patent Reference 4]: Japanese Patent Application No. 2005-66543
[Non-Patent Reference 1] : Chen et al., J. Crystal Growth, 209, page 208 (2000)

DISCLOSURE OF THE INVENTION

An object of the present invention is to increase the yield of a crystal by preventing attachment of a deposit, which is a problem in conventional techniques described above, without causing upsizing or complication of a crystal production apparatus. Another object of the present invention is to attain cost reduction and improve the crystal purity by minimizing the amount of a noble metal used in a reaction vessel such as autoclave for preventing an impurity from mixing into the crystal.

Still another object of the present invention is, with respect to a reaction vessel having an inlet tube or a valve, to prevent clogging of the inlet tube or valve and/or erosion on the inner surface of the inlet tube or valve, which are problems found by the present inventors, and improve the crystal purity.

As a result of intensive studies to attain these objects, the present inventors have found that, in the production of a crystal by using a solvent in the supercritical state and/or subcritical state, when a substance differing in the critical density from the solvent and satisfying predetermined conditions is present in a reaction vessel, this brings about an unexpectedly high effect on the control of the precipitation position of the crystal and/or mineralizer in the reaction vessel and there is obtained an effect of preventing mixing of an impurity such as transition metal component into the crystal or in the case of a reaction vessel having an inlet tube or the like, an effect of preventing precipitation of the crystal and/or mineralizer in the inlet tube or valve and thereby preventing clogging of the inlet tube or valve. The present invention has been accomplished based on this finding.

That is, a first gist of the present invention resides in a crystal production process comprising growing a crystal by using a solvent in the supercritical state and/or subcritical state in a reaction vessel, wherein a substance (X) satisfying the following formula (1) and having a critical density difference of 25% or more from the solvent is allowed to be present in the reaction vessel and the precipitation position of the crystal is controlled by adjusting the amount of the substance (X). The first gist of the present invention resides also in the crystal production process, wherein the amount of a reaction vessel-derived metal element contained in the grown crystal is controlled by adjusting the amount of the substance (X) under the above-described conditions.

$$\frac{\text{(solubility of raw material in substance (X))}}{\text{(solubility of raw material in solvent)}} \times 100 \leq 20 \quad (1)$$

A second gist of the present invention resides in a crystal production process comprising growing a crystal by using a solvent in the supercritical state and/or subcritical state in a reaction vessel with a part of the inner surface being formed of a non-noble metal, wherein a substance (X') having a critical density difference of 25% or more from the solvent and substantially incapable of reacting with the reaction vessel is allowed to be present in the reaction vessel and during the crystal growth, the inner surface portion except for a noble metal is covered with the substance (X').

A third gist of the present invention resides in a crystal production apparatus using a solvent in the supercritical state and/or subcritical state, the apparatus comprising a metering mechanism for adding a substance differing in the critical density from the solvent at a predetermined ratio to a reaction vessel.

A fourth gist of the present invention resides in a crystal comprising a nitride of a Periodic Table Group 13 element, produced by a crystal production process of growing a crystal by using a solvent in the supercritical state and/or subcritical state and a raw material in a reaction vessel, wherein the Cr content is $9 \times 10^{14}$ cm$^{-3}$ or less and the Fe content is $9 \times 10^{16}$ cm$^{-3}$ or less.

A fifth gist of the present invention resides in a device using the crystal.

According to the crystal production process in the first gist of the present invention, the precipitation of a crystal and/or a mineralizer on a specific site in a vessel can be easily controlled and the yield of the obtained crystal can be greatly enhanced without causing upsizing or complication of a crystal production apparatus. Also, in a reaction vessel having an inlet tube or a valve, a crystal and/or a mineralizer can be prevented from precipitating in the inlet tube or valve and therefore, a crystal can be efficiently produced without causing clogging of the inlet tube or valve.

According to the crystal production process in the second gist of the present invention, a reaction vessel-derived transition metal component resulting from erosion of the inner surface of the reaction vessel in the portion except for a noble metal can be prevented from mixing into the crystal and a high-purity crystal can be widely applied to the field of electronics, optics or the like. Also, the inner surface of the reaction vessel needs not be entirely formed of a noble metal. Furthermore, in a reaction vessel having an inlet tube or the like, the inner surface of the inlet tube or the like needs not be formed of a noble metal, so that the structure of the reaction vessel can be simplified and the amount of a noble metal used and in turn, the cost can be reduced.

According to the crystal production apparatus in the third gist of the present invention, a substance differing in the critical density from the solvent can be added in a predetermined amount by the metering mechanism, so that the precipitation position of a crystal and/or a mineralizer can be controlled, mixing of an impurity into the crystal due to erosion of the reaction vessel can be prevented, and a high-purity crystal can be obtained in a good yield.

The crystal in the fourth gist of the present invention has less impurity and high crystallinity, so that the number of the lattice defects or dislocation density can be low and formation of an impurity level can be reduced.

BRIEF DESCRIPTION OF THE DRAWINGS

Fig. 1 is a schematic cross-sectional view of a crystal production apparatus having an inlet tube at the upper portion, which is used in the present invention.

Fig. 2 is a schematic cross-sectional view of a crystal production apparatus having an inlet tube at the lower portion, which is used in the present invention.

Fig. 3 is a view showing a substance adding device using a metering cylinder, which is used in the crystal production apparatus of the present invention.

Fig. 4 is a schematic cross-sectional view of a crystal production apparatus using an autoclave sealed with a gasket or a packing.

Fig. 5 is a schematic cross-sectional view of a crystal production apparatus according to a solvothermal method using a container for crystal growth.

Fig. 6 is a substance adding device using a metering syringe, which is used in the crystal production apparatus of the present invention.

In the Figures, 1 is a valve, 2 is a manometer, 3 is an autoclave, 3a is a cover material, 3b is a reactor body, 4 is a crystal growth part, 5 is a raw material filling part, 6 is a baffle plate, 7 is an electric furnace, 8 is a thermocouple, 9 is a raw material, 10 is seed crystal, 11 is a gasket or a packing, 12 is a metering cylinder, 13 is a manometer, 14 is a valve, 15 is an inlet tube, 16 is a container, and 17 is a syringe.

BEST MODE FOR CARRYING OUT THE INVENTION

The crystal production process and the crystal production apparatus of the present invention are described in detail below, but the following description of the constituent elements is only one example of the embodiment of the present invention, and the present invention is not limited to these contents. Incidentally, the numerical value range shown by using the term "(numerical value A) to (numerical value B)" in the present specification means a range including the numerical values A and B as a lower limit value and an upper limit value, respectively.

The present invention is characterized in that a predetermined amount of a substance differing in the critical density from a solvent, as represented by helium (He) and nitrogen ($N_2$), is allowed to be present in a reaction vessel, whereby the solvent in the supercritical state and/or subcritical state (hereinafter referred to as a "supercritical solvent") is prevented from contacting with the upper or lower part on the inner wall of the reaction vessel or in the case of a reaction vessel having an attached inlet tube, intrusion of the supercritical solvent into the inlet tube is avoided, as a result, a high-purity crystal is easily obtained by controlling the precipitation of a crystal and/or a mineralizer on a specific site in the reaction vessel.

The reaction vessel for use in the present invention is not particularly limited as long as it can be applied to the crystal growth using a supercritical solvent, and, for example, an autoclave is preferred. In the following, the present invention is specifically described by referring to embodiments using an autoclave which is a representative example of the reaction vessel, but the present invention is not limited to these embodiments.

First, the ammonothermal method of growing a Group 13 nitride crystal by using a nitrogen-containing solvent such as ammonia is described as an example by appropriately referring to the drawings.

[Apparatus]

As described above in BACKGROUND ART, Fig. 4 is a schematic view of a production apparatus according to a solvothermal method, and this apparatus is also used in the ammonothermal method. Reference numeral 3 denotes an autoclave, reference numeral 4 denotes a crystal growth part, reference numeral 5 denotes a raw material filling part, reference numeral 6 denotes a baffle plate, reference numeral 7 denotes an electric furnace, reference numeral 8 denotes a thermocouple, reference numeral 9 denotes a raw material, and reference numeral 10 denotes a seed crystal.

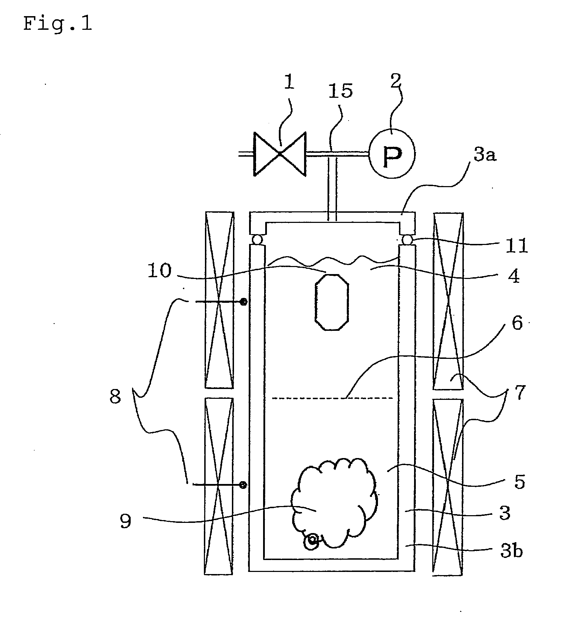

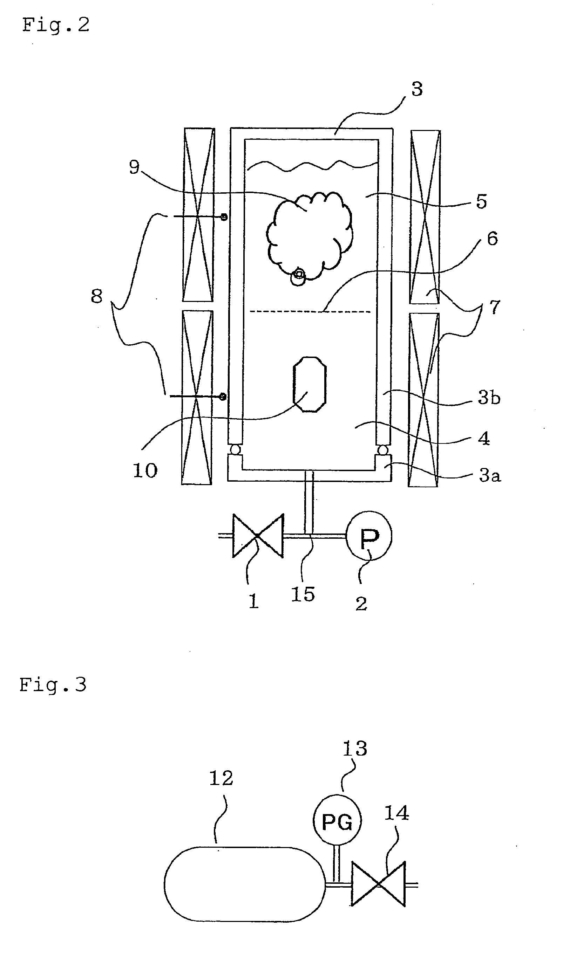

The construction of the autoclave is described. As shown in Fig. 4, the autoclave is usually separated into a cover material and a reactor body and is sealed by using a gasket or the like (reference numeral 3a is a cover material, reference numeral 3b is a reactor body, and reference numeral 11 is a gasket or the like). The autoclave may have a recessed part (not shown) for the insertion of a thermocouple or the like. As shown in Figs. 1 and 2, an autoclave having an inlet tube (reference numeral 15 is an inlet tube) is also included.

The autoclave is preferably an autoclave capable of withstanding the pressure corresponding to the extreme pressure of the supercritical ammonia during the temperature-rising reaction. The material constituting the autoclave is not particularly limited, but an Ni-based alloy or a Co-based alloy such as Stellite (registered trademark of Deloro Stellite Company Incorp.), which can withstand high temperature and high pressure and exhibit high erosion resistance against ammonia, is preferably used. An Ni-based alloy is more preferred, and specific examples thereof include Inconel 625 (Inconel is a registered trademark of Huntington Alloys Canada Ltd., hereinafter the same), Nimonic 90 (Nimonic is a registered trademark of Special Metals Wiggin Ltd., hereinafter the same) and RENE 41.

The composition ratio of such an alloy may be appropriately selected according to the conditions of temperature·pressure of the solvent in the system, the reactivity and/or oxidizability·reducibility with various mineralizers contained in the system or a reaction product thereof, and the pH condition. The method of using such an alloy as a material constituting the inner surface of the autoclave may be a method of producing the autoclave itself by using such an alloy, a method of forming a thin film as an inner cylinder and disposing it in the autoclave, or a method of applying a plating treatment to the inner surface of an arbitrary autoclave material.

In order to more enhance the erosion resistance of the autoclave, the inner surface of the autoclave may be lined or coated with a noble metal for utilizing the excellent erosion resistance of the noble metal. Also, a noble metal may be used as the construction material of the autoclave. The noble metal includes Pt, Au, Ir, Ru, Rh, Pd, Ag and an alloy mainly comprising such a noble metal. Among these, Pt is preferred because of its excellent erosion resistance.

In the case of lining or coating the inner surface of the autoclave with a noble metal, when the inner surface is difficult to be entirely lined or coated, the autoclave may have an unlined or uncoated portion at a part of the upper part and/or a part of the lower part. In the second gist of the present invention where the inner surface portion except for a noble metal is covered with a substance (X'), a noble metal preferably occupies 80% or more, preferably 90% or more, of the inner surface of the autoclave, but a surface portion except for a noble metal must be present. Actually, in the case of sealing the autoclave by welding, since the entire inner surface in the welded portion can be hardly formed of a noble metal, or in the case of using a gasket or the like, when the surface of the gasket or the like is formed of a material which is not a noble metal, there is present at least a surface portion except for a noble metal, such as welded portion and gasket or the like. Furthermore, in the case of an autoclave having an inlet tube, the inner surface of the inlet tube may not be a noble metal.

In the present invention, the upper part of the autoclave means a portion vertically above the center portion of the autoclave but is preferably a portion within 20% or less of the length from the top in the longitudinal direction of the vessel, more preferably the top surface of the vessel. Also, the lower part of the autoclave means a portion vertically below the center portion of the autoclave but is preferably a portion within 20% or less of the length from the bottom in the longitudinal direction of the vessel, preferably the bottom surface of the vessel.

As shown in Fig. 4, the gasket or the like used for the sealing of the autoclave comprising a cover material and a reactor body may be sufficient if it can withstand the pressure corresponding to the extreme pressure of the supercritical ammonia. For example, a gasket or the like comprising a general material such as Ni-based alloy may be used.

If desired, a baffle plate (reference numeral 6) is disposed in the autoclave to divide the inside into a raw material filling part filled with a raw material comprising a GaN polycrystalline nitride and a crystal growth part having disposed therein a GaN seed crystal. A baffle plate having a hole area ratio of 2 to 10% is preferred. By controlling the hole area ratio of the baffle plate, the convection of the supercritical solvent can be controlled and the proper control of the supersaturation degree of GaN in the crystal growth part under the growth conditions is facilitated.

The term "supersaturation" as used herein means a state where the dissolution amount is increased to exceed the saturated state, and the term "supersaturation degree" means, as represented by the following formula (4), a ratio of the dissolution amount in the supersaturated state to the dissolution amount in the saturated state. In the solution growth method, this means a ratio between the dissolution amount of GaN in the crystal growth part put into a supersaturated state as a result of transport of GaN by the convection from the raw material filling part and the dissolution amount of GaN in the saturated state of the crystal growth part.

$$\text{Supersaturation degree} = \frac{\text{dissolution amount in supersaturated state of crystal growth part}}{\text{dissolution amount in saturated state of crystal growth part}} \quad (4)$$

Incidentally, in the present invention, the supersaturation degree can be controlled by appropriately changing or selecting, for example, the filling amount of the raw material nitride, the hole area ratio of the baffle plate, or the temperature difference between the raw material filling part and the crystal growth part.

The baffle plate may be formed of the same material as that used for the autoclave, but in order to impart higher erosion resistance and produce a high-purity crystal, the surface of the baffle plate is preferably formed of nickel (Ni), tantalum (Ta), titanium (Ti) or niobium (Nb), more preferably a noble metal such as palladium (Pd), platinum (Pt) and gold (Au), still more preferably platinum (Pt).

Figs. 1 and 2 each is a schematic cross-sectional view of a crystal production apparatus having an inlet tube, which is used in the production process of the present invention, and an inlet tube for supplying a solvent or the like is disposed at the upper part or the lower part of the autoclave. Reference numeral 1 denotes a valve, reference numeral 2 denotes a manometer, reference numeral 3 denotes an autoclave, reference numeral 4 denotes a crystal growth part, reference numeral 5 denotes a raw material filling part, reference numeral 6 denotes a baffle plate, reference numeral 7 denotes an electric furnace, reference numeral 8 denotes a thermocouple, reference numeral 9 denotes a raw material, reference numeral 10 denotes a seed crystal, and reference numeral 15 denotes an inlet tube. Here, the upper part and the lower part of the autoclave have the same meanings as above.

The shape of the inlet tube is not limited to a cylindrical form, and the shape, length and the like may be arbitrarily selected. The inlet tube is located at the top center of the autoclave in Fig. 1 or at the bottom center of the autoclave in Fig. 2 but may be decentered or may be located on the side surface in the upper or lower part of the autoclave.

In Figs. 1 and 2, a valve 1 and a manometer 2 attached to the inlet tube 15 are shown, but these are not essential members and it may suffice if the autoclave can be sealed up. However, the valve is effective for the simplification of sealing operation, and the manometer is effective for the monitoring of pressure during crystal growth.

The construction material of the inlet tube is preferably a material having erosion resistance against the nitrogen-containing solvent, but an inlet tube comprising a general material such as SUS316 (JIS standard) may be used. Use of Inconel 625 is more preferred.

The construction material of the value is also preferably a material having erosion resistance against the nitrogen-containing solvent, but a valve comprising a general material such as SUS316 (JIS standard) may be used.

The construction material of the manometer is also preferably a material having erosion resistance against the nitrogen-containing solvent, but a valve comprising a general material such as SUS316 (JIS standard) may be used. Use of Inconel 625 is more preferred.

As for the apparatus used in the crystal production of the present invention, an apparatus fundamentally the same as the conventional apparatus may be used as long as it has a device of performing the crystal growth by using a solvent in the supercritical state and/or subcritical state, but as described later, in the crystal production method where a substance differing in the critical density from the solvent is added to the autoclave, a crystal production apparatus having a metering device for adding the substance at a predetermined ratio to the autoclave is used. By the use of such an apparatus, a substance differing in the critical density from the solvent can be added in a predetermined amount and this effectively enables to prevent clogging of the inlet tube, prevent attachment of a deposit to the autoclave, improve the crystal purity or prevent erosion of the autoclave.

[Crystal Production]

In the case of the ammonothermal method, the crystal as an objective of the production is a Group 13 nitride crystal and depends on the Group 13 element in the raw material but mainly, a nitride crystal of a single metal (e.g., GaN, AlN) of a Group 13 element such as B, Al, Ga and In, or a nitride crystal of an alloy thereof (e.g., GaInN, GaAlN) is preferred, and gallium nitride is more preferred.

The crystal produced may be either a single crystal or a polycrystal. The polycrystal can be applied, for example, to purification of a crystal raw material for preparing a raw material for the production of a single crystal or to a dopant for the addition of an impurity. A single crystal is more preferred, because this can be applied to a substrate for the production of an electronic device or a light-emitting device such as LED. The size of the single crystal obtained by the ammonothermal method varies depending on the conditions such as the size of autoclave or the size of seed crystal but in the case of an autoclave having an inner diameter of 100 mm, a single crystal having a size of $\phi$3 inches can be obtained.

In the case where the objective is a Group 13 nitride compound crystal, the raw material for the production thereof is usually a polycrystalline raw material containing a Group 13 nitride crystal, preferably a gallium nitride-containing raw material. The polycrystalline raw material needs not be a complete nitride and depending on the condition, may contain a metal component where the Group 13 element is in the metal state (that is, zero valence). In the case where the crystal is gallium nitride, examples of the polycrystalline raw material include a mixture of gallium nitride and metal gallium.

The production process of the polycrystalline raw material as the raw material for the crystal production is not particularly limited. For example, a nitride polycrystal produced by reacting a metal or an oxide or hydroxide thereof with ammonia in a reaction vessel having flowed therein an ammonia gas may be used. Also, a compound having a covalent bonding M-N bond, such as halide, amide compound, imide compound and gallazane, may be used as the metal compound raw material having higher reactivity. Furthermore, a nitride polycrystal (e.g., GaN) produced by reacting a metal such as Ga with nitrogen at high temperature and high pressure may also be used.

In order to obtain a high-quality crystal through crystal growth of the polycrystalline raw material, mixing of water or oxygen into the polycrystalline raw material should be avoided as much as possible. Therefore, the oxygen content in the polycrystalline raw material is usually 5 mass% or less, preferably 2 mass% or less, more preferably 0.5 mass% or less. The easy mixing of oxygen into the polycrystalline raw material is related with reactivity with water or water absorptivity. As the crystallinity of the polycrystalline raw material is poorer, a larger number of active groups such as NH group are present on the surface or the like and such an active group may react with water to partially produce an oxide or a hydroxide. Accordingly, it is usually preferred to use a polycrystalline raw material having crystallinity as high as possible. The crystallinity may be estimated from the half-width of the powder X-ray diffraction. In a preferred polycrystalline raw material, the half-width of (100) diffraction line (in the case of hexagonal gallium nitride, $2\theta$=about 32.5°) is usually 0.25° or less, preferably 0.20° or less, more preferably 0.17° or less.

In the case where the crystal growth is the growth of a nitride crystal by the ammonothermal method, nitrogen-containing solvents (for example, at least one compound selected from the group consisting of hydrazine $N_2H_4$, ammonia

$NH_3$, amines and melamine) and solvents miscible with a nitride III-V all may be used as the solvent filled, but the solvent is preferably ammonia $NH_3$.

It is also suitably performed to deaerate the inside of the autoclave before charging the nitrogen-containing solvent or charge the nitrogen-containing solvent while flowing an inert gas such as nitrogen. At this time, the autoclave may be cooled to a temperature lower the boiling point of the nitrogen-containing solvent. The concentration of water or oxygen contained in such a solvent is preferably lower and is preferably 1,000 ppm or less, more preferably 100 ppm or less, still more preferably 10 ppm or less. Incidentally, one kind of solvent may be used or two or more kinds of solvents may be used as a mixture.

In the case of using ammonia as the solvent, the purity is usually 99.9% or more, preferably 99.99% or more, more preferably 99.999% or more, still more preferably 99.9999% or more. Since ammonia generally has high affinity for water, at the time of filling ammonia in the autoclave, oxygen derived from water is readily carried over into the autoclave and gives rise to increase in the amount of oxygen mixed into the crystal, as a result, the crystallinity of the obtained nitrogen compound crystal may be deteriorated. Also from this standpoint, the amount of water or oxygen contained in the ammonia solvent is preferably as small as possible and is preferably 1,000 ppm or less, more preferably 100 ppm or less, still more preferably 10 ppm or less.

Such a solvent is used in the subcritical state and/or supercritical state during crystal production. The supercritical state means a concentrated gas kept at its critical temperature or more, and the critical temperature is a temperature at which the gas cannot be liquefied by a pressure. In the supercritical state, the viscosity is generally low and the gas is more easily diffused than a liquid but has the same solvation force as a liquid. The subcritical state means a liquid state having a density almost equal to the critical density in the vicinity of the critical temperature. For example, after dissolving the raw material in the supercritical state in the raw material filling part and chaining the temperature to provide a subcritical state in the crystal growth part, the crystal growth may be performed by utilizing the difference in the solubility of the raw material between the supercritical state and the subcritical state.

At the crystal growth, a mineralizer is preferably used in view of increasing the crystal growth rate. The mineralizer (also called a solubilizing agent) is a substance for elevating the solubility of the raw material in the solvent and transferring the crystal raw material to the crystal growth part, and this substance is well known in this field. The dissolution as used in the present invention includes both physical dissolution and chemical dissolution.

The mineralizer is usually a compound containing a halogen atom, an alkali metal, an alkaline earth metal or a rare earth metal. Among these, from the standpoint of producing a crystal containing no oxygen, a compound containing a nitrogen atom in the form of ammonium ion or amide is preferably used as the mineralizer. One of these mineralizers may be used, or two or more kinds thereof may be used in combination. In order to prevent mixing of an impurity into the nitride crystal, the mineralizer is purified or dried, if desired. The purity of the mineralizer is usually 95% or more, preferably 98% or more, more preferably 99% or more, still more preferably 99.5% or more. The amount of water or oxygen contained in the mineralizer is preferably as small as possible and is preferably 1,000 ppm or less, more preferably 100 ppm or less.

The mineralizer is classified into an acidic mineralizer and a basic mineralizer.
The basic mineralizer is a compound containing an alkali metal, an alkaline earth metal or a rare earth metal and a nitrogen atom, and examples thereof include an alkaline earth metal amide, a rare earth amide, an alkali metal nitride, an alkaline earth metal nitride, an azide compound, and a salt of hydrazines. An alkali metal amide is preferred and specific examples thereof include sodium amide ($NaNH_2$), potassium amide ($KNH_2$) and lithium amide ($LiNH_2$).
The acidic mineralizer is a compound containing a halogen atom, and examples thereof include an ammonium halide such as ammonium chloride ($NH_4Cl$), ammonium iodide ($NH_4I$) and ammonium bromide ($NH_4Br$). Among these, ammonium chloride ($NH_4Cl$) is preferred.

In the case of the ammonothermal method using ammonia as the solvent, an acidic mineralizer is preferred, because the acidic mineralizer has high solubility in the ammonia solvent in the supercritical state, exerts nitridation ability in ammonia, and exhibits low reactivity with a noble metal such as Pt.

As for the ratio of mineralizer and raw material used, the mineralizer/Group 13 metal element (by mol) is usually from 0.001 to 100. For example, in the case of GaN, usually, the mineralizer/Ga ratio by mol is preferably from 0.001 to 20 and may be appropriately selected by taking account of the kind of the raw material or additive (e.g., mineralizer) or the objective crystal size.

In the present invention, in order to grow a crystal at a predetermined position, a seed crystal is preferably used. The present invention includes not only the production of a single crystal but also the production of a polycrystal and when a seed crystal is used, production of a single crystal on the seed crystal is accelerated and a lager single crystal can be obtained. The seed crystal is usually loaded simultaneously with or after the loading of the raw material and an additive such as mineralizer, and the seed crystal is fixed to a jig made of the same noble metal as the noble metal constituting the inner surface of the autoclave. After the loading into the autoclave, heating and deaeration are also effectively performed, if desired.
The loading position of the seed crystal in the autoclave is determined by taking into consideration the status where a gasket or an inlet tube is disposed. For example, as shown in Fig. 1, when a gasket 11 is present in the upper part of the autoclave, the seed crystal is loaded such that the top end of the seed crystal is positioned lower than the bottom end of the gasket. The top end of the seed crystal is preferably positioned 2 cm or more lower, more preferably 3 cm or more lower, still more preferably 5 cm or more lower, than the bottom end of the gasket.

Also, in the present invention, the amount of the substance (X) or (X') allowed to be present in the autoclave during crystal growth is preferably determined by taking account of the loading position of the seed crystal. For example, in the case of performing the crystal growth in an autoclave having a gasket at the upper part by using a substance (X) or (X') having a critical density smaller than that of the solvent, assuming that the substance (X) or (X') is unevenly distributed to the upper part in the autoclave during crystal growth, the substance is preferably used in an amount large enough to fill to the position lower than the bottom end of the gasket, more preferably to the position 2 cm or more lower, still more preferably 3 cm or more lower, yet still more preferably 5 cm or more lower, than the bottom end of the gasket. However, the amount of the substance is preferably not large enough to reach the top end of the seed crystal. In the case where an inner surface comprising a non-noble metal is present in the upper part of the autoclave, the amount of the substance (X) or (X') can be determined in the same manner as in the case of a gasket by using the bottom end of the non-noble metal portion as the basis.

In the case where a gasket or a non-noble metal portion is present in the lower part of the autoclave, after loading the seed crystal such that the bottom end of the seed crystal is positioned above the top end of the gasket or non-metal portion, a substance (X) or (X') having a critical density larger than that of the solvent is used. At this time, assuming that the substance is unevenly distributed to the lower part in the autoclave, the substance is preferably used in an amount large enough to fill to the position above the top end of the gasket, more preferably to the position 2 cm or more higher, still more preferably 3 cm or more higher, yet still more preferably 5 cm or more higher, than the top end of the gasket. However, the amount of the substance is preferably not large enough to reach the bottom end of the seed crystal. In the case where an inner surface comprising a non-noble metal is present in the lower part of the autoclave, the amount of the substance (X) or (X') can be determined in the same manner as in the case of a gasket by using the top end of the non-noble metal portion as the basis.

In the case of crystal growth of a nitride single crystal by the ammonothermal method, a single crystal of the objective nitride is preferably used, but the nitride may not be necessarily the same as the objective nitride. However, in this case, it is preferred to use a seed crystal having a lattice constant and/or a crystal lattice coinciding or conforming with the objective nitride, or a seed crystal constituted by a single-crystal or polycrystal material piece coordinated to guarantee heteroepitaxy (that is, conformance in the crystallographic position of some atoms). Specific examples of the seed crystal include, in the case of gallium nitride (GaN), a GaN single crystal, a nitride single crystal such as AlN, and a silicon carbide (SiC) single crystal.

The seed crystal can be determined by taking account of solubility in the ammonia solvent and reactivity with the mineralizer. Examples of the GaN seed crystal which can be used include a single crystal grown by epitaxy on a heterogeneous substrate such as sapphire by the MOCVD or HVPE method and separated from the substrate, a single crystal obtained through crystal growth from metal Ga by using Na, Li or Bi as the flux, a single crystal obtained through homo/hetero-epitaxial growth according to the LPE method, a single crystal produced based on the solution growth method including the process of the present invention, and a crystal obtained by cutting such a single crystal.

In the first present invention, a substance (X) satisfying the following formula (1) and having a critical density difference of 25% or more from the solvent is allowed to be present in the autoclave, and in the second invention, a substance (X') having a critical density difference of 25% or more from the solvent and substantially incapable of reacting with the autoclave is allowed to be present in the autoclave.

$$\frac{(\text{solubility of raw material in substance (X)})}{(\text{solubility of raw material in solvent})} \times 100 \leq 20 \quad (1)$$

The substance (X) and the substance (X') each is considered to be unevenly distributed with the solvent in the autoclave due to difference in the critical density from the solvent. In order to effectively obtain the uneven distribution of the substance (X) or (X'), the critical density difference from the solvent is preferably 50% or more, more preferably 70% or more. Here, the critical density difference $\Delta\rho(A)$ from the solvent is defined by the following formula (5) (wherein A is X or X'):

$$\Delta\rho(A)=\frac{|(\text{critical density of solvent}) - (\text{critical density of substance (A)})|}{(\text{critical density of solvent})}\times100 \qquad (5)$$

The substance (X) and the substance (X') are preferably a substance which already enters the supercritical state at least when dissolving the raw material and growing the crystal and which is lower in the critical temperature and the critical pressure than the solvent. In the case where the solvent is ammonia, the critical temperature is preferably 100°C or less and the critical pressure is preferably 10 MPa or less.

With respect to the substance (X), as shown by formula (1), the solubility of the raw material in the substance (X) is 20% or less of the solubility of the raw material in the solvent. In the first invention, the solubility of the raw material in the substance (X) is 20% or less of the solubility in the solvent and at the same time, the difference in the critical density of the substance (X) from the solvent is 25% or more. Therefore, there is provided a state such that the substance (X) and the solvent are substantially distributed unevenly and the raw material is mostly dissolved in the solvent and scarcely dissolved in the substance (X). Moreover, the abundance of the substance (X) is set to a predetermined amount to thereby control the region where the solvent is present in the autoclave, and the crystal growth is performed in the region where the solvent is present, so that crystal growth in the undesired region or precipitation of the raw material can be suppressed and the precipitation position of the crystal can be controlled.
Accordingly, the solubility of the raw material in the substance (X) is preferably smaller with respect to the solubility of the raw material in the solvent and is preferably 10% or less, more preferably 5% or less.

Also, in the case of using a mineralizer, when the mineralizer is a solid matter and precipitates during or after crystal growth, in view of preventing the mineralizer from precipitation in the undesired region, that is, controlling the precipitation position of the mineralizer, as shown in the following formula (2), the solubility of the mineralizer in the substance (X) is 20% or less, preferably 10% or less, more preferably 5% or less, of the solubility of the mineralizer in the solvent.

$$\frac{(\text{solubility of mineralizer in substance (X)})}{(\text{solubility of mineralizer in solvent})}\times100\leq20 \qquad (2)$$

Incidentally, the solubility of the raw material or mineralizer in the substance (X) is difficult to directly measure. Therefore, in the present invention, whether formula (1) or (2) is satisfied is judged by measuring the weight of the raw material or mineralizer precipitated in the undesired region within the autoclave when not using the substance (X) and the weight of the raw material or mineralizer precipitated in the undesired region when using the substance (X), and determining the ratio therebetween. That is, (weight of the latter) / (weight of the former) $\times$ 100 is calculated and when the value obtained is 20% or less, it can be judged that the formula (1) or (2) is satisfied. The undesired region is described here by referring to Figs. 1 and 2. In Fig. 1, the undesired region includes the portion above the seed crystal 10 and/or the portion below the raw material 9 in the autoclave 3, and in Fig. 2, the undesired region includes the portion below the seed crystal 10 and/or the portion above the raw material 9 in the autoclave 3. In the case of an autoclave having an inlet tube, the undesired region also includes the inside of the inlet tube.

On the other hand, the substance (X') needs to be a substance substantially incapable of reacting with the autoclave. The "substantially incapable of reacting" means that the autoclave is not eroded by the substance (X') and in the grown crystal, the concentration of an impurity derived from an element contained in the autoclave is 1% or less, preferably 500 ppm or less, more preferably 100 ppm or less. For example, in the case where the solvent is ammonia and the autoclave is made of Inconel, chromium (Cr), iron (Fe), nickel (Ni), tantalum (Ta) and the like are detected as the impurity. The analysis method is GDMS (glow discharge mass spectrometry).
In the second invention, the inner surface portion except for a noble metal is covered with the substance (X'), whereby in the grown crystal obtained, the concentration of an impurity derived from an element contained in the autoclave can be reduced.

Also, in the case of using a mineralizer, when the mineralizer is a solid matter and precipitates during or after crystal growth, in view of preventing the mineralizer from precipitation in the undesired region, that is, controlling the precipitation position of the mineralizer, the substance (X') satisfies, similarly to the substance (X), the condition that as shown in the following formula (3), the solubility of the mineralizer in the substance (X') is 20% or less, preferably 10% or less, more preferably 5% or less, of the solubility of the mineralizer in the solvent.

$$\frac{(\text{solubility of mineralizer in substance (X')})}{(\text{solubility of mineralizer in solvent})} \times 100 \leq 20 \quad (3)$$

The relationship in the size of the critical density between the substance (X) or (X') and the solvent is determined by the presence or absence of an inlet tube connected to the autoclave, the construction material used for the inner surface of the autoclave, and the like. Specifically, when an inlet tube is disposed in the upper part as in Fig. 1, at least one substance having a critical density smaller than that of the solvent is allowed to be present, and when an inlet tube is disposed in the lower part of the autoclave as in Fig. 2, at least one substance having a critical density larger than that of the solvent is allowed to be present. In the case where an inlet tube is disposed in the upper and lower portions, a substance having a critical density smaller than that of the solvent and a substance having a critical density larger than that of the solvent are allowed to be present together. Then, a substance (X) or (X') comes to be present inside the inlet tube, as a result, precipitation of a crystal in the inside of the inlet tube is suppressed and the crystal precipitation position is controlled.

In order to suppress the precipitation of a crystal and/or a mineralizer in the undesired region, that is, control the crystal precipitation position, the amount of the substance (X) allowed to be present may be sufficient if it is a previously determined amount (predetermined amount) necessary for the substance (X) to fill such a region. In the case of using an autoclave having an inlet tube, it may suffice if the inlet tube portion can be covered with the substance (X) during crystal production, and the amount of the substance allowed to be present may be 1 time or more the volume of the inlet tube part. Specifically, the substance is allowed to be present such that the volume at the critical point of the substance (X) differing in the critical density becomes 1 time or more, preferably 1.1 times or more, more preferably 1.2 times or more, the volume of the inlet tube part.

As for the volume at the critical point, a predetermined amount can be calculated from the critical pressure Pc (X) and the critical temperature Tc(X) of the substance (X) according to the Boyle-Charle's law.

Here, the volume of the inlet tube part means the volume of a space in the inlet tube between the boundary surface of the autoclave with the inlet tube and the valve portion in the upper part of the inlet tube. If the amount of the substance differing in the critical density is less than 1 time the volume of the inlet tube, the crystal and/or mineralizer may precipitate to clog the inlet tube, or the inlet tube may be eroded to cause introduction of an impurity into the grown crystal.

In the case of an autoclave having an inlet tube, the substance (X') needs to be substantially incapable of reacting with the inlet tube. The "substantially incapable of reacting with the inlet tube" means, similarly to the autoclave above, that the grown crystal does not contain an inlet tube-derived impurity and in the grown crystal, the concentration of an impurity derived from an element contained in the inlet tube is 1% or less, preferably 500 ppm or less, more preferably 100 ppm or less. The same applies to the case where the inlet tube has a valve and a manometer. The analysis method is the same as described above. Also, similarly to the substance (X), it may suffice if the inlet tube portion can be covered with the substance (X') during crystal production, and the amount of the substance allowed to be present may be 1 time or more the volume of the inlet tube part. The predetermined amount for the substance (X') can also be calculated in the same manner as that for the substance (X).

The substance (X) and the substance (X') are not particularly limited as long as the above-described specific conditions of the present invention are satisfied by the solvent, the raw material and/or the construction material of the autoclave, but in the case where the solvent is ammonia, examples of the substance having a small critical density include hydrogen (86.7%) and helium (70.4%), and examples of the substance having a large critical density include nitrogen (32.9%) and chlorine (144.9%). Here, the numeral in the parenthesis indicates the critical density difference from ammonia.

Incidentally, in the case where the solvent is ammonia and the raw material is gallium nitride, the solubility ratio represented by formula (1) is 15% or less in all of hydrogen, helium, nitrogen and chlorine. Alternatively, the substance is a substance substantially incapable of reacting with an autoclave where the inner surface of the autoclave comprises a noble metal such as platinum.

Furthermore, in the case where the mineralizer is ammonium chloride, the solubility ratio represented by formula (2) is 15% or less in all of hydrogen, helium, nitrogen and chlorine.

The substance (X) and the substance (X') each may also be produced, for example, by the decomposition of the solvent, the reaction of the solvent substance with the raw material, the decomposition of the mineralizer, or the reaction of the mineralizer with the raw material, and thereby allowed to be present in the autoclave. In the crystal growth of growing a gallium nitride crystal by using ammonia as the solvent, when metal Ga is used in combination with the raw material polycrystalline GaN, the metal Ga can react with ammonia to generate hydrogen differing in the critical density from ammonia. According to the following reaction formula (6), hydrogen ($H_2$) in a molar amount of 1.5 times the metal Ga added is generated. Therefore, by previously adjusting the amount of the metal Ga component in the raw material to a predetermined amount, hydrogen differing in the critical density from ammonia may be generated in the autoclave to control the precipitation position of the crystal and/or mineralizer. Also, when hydrogen generated is not enough, the shortfall may be made up by adding hydrogen so as to control the precipitation position of the crystal and/or mineralizer.

$$2Ga+2NH_3 \rightarrow 2GaN+3H_2 \qquad (6)$$

In the case of adding the substance (X) or (X'), the substance may be previously added to the autoclave by using a crystal production apparatus having a metering device for adding the substance at a predetermined ratio to the autoclave. In order to add a substance having a critical density differing from that of the solvent substance into the autoclave with good reproducibility, when the substance is a gas at ordinary temperature, as shown in Fig. 3, the substance is once filled under a predetermined pressure in a metering cylinder 12 having a known inner volume, the pipeline is connected to the autoclave, a valve 14 is opened and after confirming by a manometer 12 that the pressure becomes equivalent, the valve is closed, whereby the substance can be added. The amount added is determined from the difference in the weight of the autoclave between before and after the addition, or since the pressure is equivalent, the amount added may also be determined by the Boyle-Charle's law. Furthermore, as shown in Fig. 6, a predetermined amount of the substance may be weighed by a syringe 16 and added to the autoclave. Other than these, the substance may be added with good reproducibility by using a flowmeter such as mass flow controller.

The crystal production process in the first gist of the present invention is described in detail below.
As shown in Figs. 1 and 2, a mineralizer and a raw material are filled in an autoclave and after disposing a baffle plate and a seed crystal, a solvent is filled through in inlet tube. Thereafter, a predetermined amount of a substance (X) differing in the critical density is added. At this time, when the substance (X) is generated in the system from the raw material, solvent or the like, the amount of the raw material, solvent or the like may be adjusted to generate a predetermined amount of the substance (X). Also, a predetermined amount of the substance may be allowed to be present by both the generation in the system and the addition. The substance (X) is unevenly distributed to the upper part and/or the lower part in the autoclave and must be kept not to come into contact with the seed crystal and the raw material. The solubility of the raw material in the substance (X) is lower than that in the solvent and therefore, the crystal and/or mineralizer can be prevented from precipitating in the inlet tube or in the upper part and/or the lower part of the autoclave. However, if the seed crystal or the raw material comes into contact with the substance (X), this may cause decrease in the solubility of the raw material and/or inhibition of the crystal growth on the seed crystal.

In order to perform the crystal production in the supercritical state, the system is generally kept at a temperature higher than the critical point of the solvent. In the case of using ammonia as the solvent, the critical point is at a critical temperature of 132°C and a critical pressure of 11.35 MPa. However, if the filling factor for the autoclave is high, the pressure becomes by far higher than the critical pressure even at a temperature lower than the critical temperature. The supercritical state as used herein includes also such a state exceeding the critical pressure. Since the reaction mixture is sealed in a constant volume (reactor volume), the rising of temperature leads to increase in the fluid pressure. In general, when the temperature T is T>Tc (Tc: critical temperature of solvent) and the pressure is P>Pc (Pc: critical pressure of solvent), the solvent is in the supercritical state. Under the above-described conditions, production of a GaN fine crystal is confirmed. Actually, the solubility of the polycrystalline raw material introduced into the solvent greatly differs between the subcritical condition and the supercritical condition. In the supercritical condition, a sufficiently high growth rate of a GaN single crystal can be obtained. The reaction time depends particularly on the reactivity of the mineralizer and the thermodynamic parameters, that is, the numerical values of temperature and pressure.

In the case of an ammonia solvent, the temperature range at least in the autoclave (that is, the temperature range in the reaction vessel 3) is preferably set such that the lower limit is usually 150°C, preferably 200°C, more preferably 300°C, and the upper limit is usually 800°C, preferably 700°C, more preferably 650°C.

The autoclave is divided into two overlapping zones, that is, a raw material filling part in the lower part and a crystal growth part in the upper part, which are separated by a baffle plate. The temperature gradient ΔT between these two zones is from 10 to 100°C. The direction of the gradient depends particularly on the solubility of the raw material, which is used as a function of the temperature.

During crystal growth, the autoclave is kept at a pressure of about 15 MPa to 600 MPa. In the case where the solvent is ammonia, the pressure range in the autoclave is preferably kept such that the lower limit is usually 20 MPa, preferably 30 MPa, more preferably 50 MPa, and the upper limit is usually 500 MPa, preferably 400 MPa, more preferably 200 MPa.

In order to attain the above-described temperature range and pressure range in the autoclave, the injection ratio, that is, filling factor of the ammonia solvent is usually from 20 to 95%, preferably from 40 to 90%, more preferably from 50 to 85%, based on the liquid density of ammonia in the standard state (when ammonia is a gas in the standard state, the liquid density at the boiling point) in the free volume of the autoclave, that is, when a raw material and a seed crystal are used in the autoclave, the volume remaining after subtracting the volumes of the seed crystal and a structure for placing the seed crystal thereon from the entire volume of the autoclave, or when a baffle plate is disposed, the volume remaining after further subtracting the volume of the baffle plate.

The reaction time after reaching a predetermined temperature varies depending on the kind of the nitride crystal, the kind of the raw material or mineralizer used, or the size or amount of the crystal produced but is usually from several hours to several months. During the reaction, the reaction temperature may be kept constant or the temperature may be gradually elevated or lowered. After the passing of the reaction time necessary for producing a desired crystal, the temperature is lowered. The temperature dropping method is not particularly limited but the autoclave may be left standing as it is in the furnace after stopping the heating of a heater and allowed to cool, or the autoclave may be taken out from the electric furnace and air-cooled. If desired, rapid cooling by using a coolant is also preferred.

After discharging the solvent from the inlet tube and if desired, further thoroughly removing the solvent in the autoclave by creating a vacuum state or the like, the autoclave is dried and opened, whereby a nitrogen compound crystal resulting from crystal growth, the unreacted raw material and the additive such as mineralizer can be taken out. In this way, by allowing a predetermined amount of the substance (X) to be present in the autoclave, clogging of the inlet tube due to a deposit or the attachment of a deposit to the autoclave can be prevented.

The crystal production process in the second gist of the present invention is described in detail blow. This crystal production process is fundamentally the same as the crystal production process in the first gist except that a part of the inner surface of the autoclave is formed of a noble metal, a substance (X') is used in place of the substance (X), and the crystal production is performed while the portion except for the noble metal on the inner surface of the autoclave is covered with the substance (X').

In the crystal production process according to the second gist of the present invention, when the inner surface comprising a non-noble metal is present in the upper part of the reaction vessel, the crystal can be grown in the portion lower than the inner surface comprising a non-noble metal by using a substance (X') having a critical density smaller than the critical density of the solvent. In the case where the inner surface comprising a non-noble metal is present in the lower part of the reaction vessel, the crystal can be grown in the portion higher than the inner surface comprising a non-noble metal by using a substance (X') having a critical density larger than the critical density of the solvent. In the case where the inner surface comprising a non-noble metal is present in both the upper and lower parts of the reaction vessel, the crystal can be grown in the portion which is lower than the inner surface comprising a non-noble metal in the upper part and at the same time, higher than the inner surface comprising a non-noble metal in the lower part, by using a first substance (X') having a critical density smaller than the critical density of the solvent and a second substance (X') having a critical density larger than the critical density of the solvent in combination.

For example, in the case of sealing an autoclave 3 with a gasket 11 or the like as in Fig. 4, when the inner surface of a cover material 3a or the gasket 11 or the like is not formed of a noble metal, as shown in Fig. 4, the crystal production is performed in the state that a seed crystal 10 is disposed closer to a baffle plate 6 than to the position of the gasket or the like 11 and a substance (X') in an amount large enough to cover the inner surfaces of the gasket or the gasket or the like 11 and the cover material 3a is allowed to be present in the autoclave.

In the case where the reaction vessel has an inlet tube comprising a non-noble metal at its upper part, the crystal can be grown in the portion lower than the inlet tube by using a substance (X') having a critical density smaller than the critical density of the solvent in an amount of 1 time or more the volume of the inlet tube. In the case where the reaction vessel has an inlet tube comprising a non-noble metal at its lower part, the crystal can be grown in the portion higher than the inlet tube by using a substance (X') having a critical density larger than the critical density of the solvent in an amount of 1 time or more the volume of the inlet tube. The substance (X') used here is selected from materials incapable of reacting with the inlet tube. The abundance of the substance (X') is preferably 1.0 times or more, more preferably 1.1 times or more, still more preferably 1.2 times or more, the volume of the inlet tube.

In the case of the thus-grown crystal, the autoclave or when having a gasket or the like or an inlet tube, the inlet tube or the like is not eroded by the solvent and an impurity derived from the autoclave or the like is not introduced into the produced crystal, so that a high-purity crystal can be obtained and the autoclave and the like can be prevented from erosion.

The hydrothermal method of growing zinc oxide (ZnO), rock crystal or the like by using water as the solvent is described below by referring to the crystal growth of zinc oxide. The hydrothermal method is fundamentally the same as the ammonothermal method except for the following differences.

[Apparatus]

In the crystal production of zinc oxide or rock crystal by the hydrothermal method, the same apparatus can also be used. At the time of growing zinc oxide, when a baffle plate is used, the hole area ratio is preferably from 5 to 15%. Similarly to the crystal growth of GaN by the ammonothermal method, by controlling the hole area ratio of the baffle plate, the proper control of the supersaturation degree of zinc oxide in the crystal growth part under the growth conditions is facilitated.

[Crystal Production]

In the hydrothermal method, the objective of production is an oxide such as zinc oxide and rock crystal. For the crystal growth of zinc oxide, a ZnO powder is used as the raw material. In order to produce a high-quality crystal, the raw material preferably a high purity, specifically a purity of 99.999% or more. In practice, a sintered body of such a ZnO power is prepared and used directly as the raw material. The preparation of the sintered body greatly affects the growth of a single crystal. By using a ZnO powder of about 1 $\mu$m on average as the ZnO for the production of a sintered body, the ZnO powder is preferably placed in a platinum-made formwork before sintering and compression-molded by a press or the like, whereby generation of a fine crystal at the crystal growth can be suppressed and waste of the raw material due to generation of a fine crystal can be avoided.

In the case of growth by the hydrothermal method, the solvent is water, preferably distilled water. The water as the solvent is used in the subcritical state and/or supercritical state during crystal production. Examples of the mineralizer include an alkali such as sodium hydroxide (NaOH), calcium carbonate (Na$_2$CO$_3$), potassium hydroxide (KOH) and lithium hydroxide (LiOH), and an acid such as phosphoric acid (H$_3$PO$_4$). In the case of crystal growth of a zinc oxide single crystal, the zinc oxide is a hexagonal crystal, but the growth rate in the axial direction can be controlled by the crystal growth conditions. The growth in the c-axis direction can be accelerated by allowing potassium (K) to be present together during growth. For this purpose, KOH is preferably used as the mineralizer. In order to accelerate the growth in the a-axis direction, lithium (Li) is preferably allowed to be present together and for this purpose, LiOH is preferably used a the mineralizer.

In the ammonothermal method, a mineralizer and a raw material are usually mixed and used, but in the case of the hydrothermal method, an alkali solution or an acid solution prepared by previously dissolving the mineralizer in water which is the solvent, is usually used by filling it in the autoclave. Because of this, such an alkali solution or acid solution is sometimes called a solvent or a solution.

As for the seed crystal, a single crystal of the objective crystal is preferably used, and this is zinc oxide in the case of zinc oxide, and rock crystal in the case of rock crystal. The seed crystal may have an arbitrary shape such as quadratic prism, hexagonal prism or cylinder. In the case of crystal growth of zinc oxide, from the standpoint of stabilizing the crystal quality in all azimuths of the crystal, a seed crystal in the form of hexagonal prism or hexagonal plate is preferred. The seed crystal may be disposed in an arbitrary direction but is preferably disposed such that the angle between the c-axis of the seed crystal and the convection direction of the oxide solvent becomes from 0 to 180° (excluding 0° and 180°), more preferably from 60 to 120°. By using a seed crystal disposed in this way, a ZnO single crystal is obtained through crystal growth proceeding eccentrically with respect to the seed crystal, as a result, a larger single crystal can be obtained.

The substances (X) and (X') having a critical density different from that of the solvent are, similarly to the ammonothermal method, not particularly limited as long as the above-described specific conditions of the present invention are satisfied by the solvent, the raw material and/or the construction material of the autoclave, but in the hydrothermal method where the solvent is water, examples of the substance having a small critical density include hydrogen (90.4%) and helium (78.6%), and examples of the substance having a large critical density include oxygen (32.7%). Here, the numeral in the parenthesis indicates the critical density difference from water.

Also, in the case where the solvent is water, the solubility ratio represented by formula (1) for the substance (X) is 15% or less in all of hydrogen, helium and oxygen, and the substance (X') is a substance substantially incapable of reacting with the autoclave. The solubility ratio represented by formula (1) and the substantial incapability of reacting with the autoclave are difficult to directly measure, but these can be determined in the same manner as in the ammonothermal method described above.

As for the mineralizer used in the hydrothermal method, when an aqueous solution prepared by dissolving the mineralizer in water at ordinary temperature and atmospheric pressure is filled in the autoclave, the precipitation of the mineralizer after crystal growth usually causes no problem. However, in the case of using a mineralizer which is a solid matter at ordinary temperature and atmospheric pressure, the solubility ratios of the mineralizer represented by formulae (2) and (3) are 15% or less in all of hydrogen, helium and oxygen. Similarly to the ammonothermal method, the solubility ratios of the mineralizer represented by formulae (2) and (3) are difficult to directly measure, but these can be determined in the same manner as in the case of the ammonothermal method.

In the crystal growth of zinc oxide of the present invention, the ratio at which the alkali or acid solution prepared by dissolving the mineralizer in the water solvent is injected is preferably from about 60 to 90% of the free volume in the autoclave, that is, the remaining volume when a ZnO sintered body as the raw material, a baffle plate and the like are disposed in the autoclave. The crystal growth is preferably performed in the supercritical state at a high temperature and a high pressure (usually from 300 to 450°C and from 50 to 150 MPa). At this time, when the temperature in the crystal growth part is set to be about 15 to 50°C lower than the temperature in the raw material filling part, a convection is generated and the raw material melted in the raw material filling part is transported to the crystal growth part and precipitates on the seed crystal, whereby the crystal is growth.

As for the details of the crystal growth part and the raw material filling part regarding the crystal growth temperature, the temperature in the crystal growth part is preferably from 300 to 360°C, and the temperature in the raw material filling part is preferably from 340 to 400°C. In this state, the operation is continued constantly for 30 to 200 days to allow the crystal growth to proceed. Thereafter, the heating furnace is stopped and cooled to room temperature, and a ZnO single crystal is taken out. The obtained bulk single crystal can be washed with hydrochloric acid (HCl), nitric acid (HNO$_3$) or the like. The size of the obtained zinc oxide crystal varies depending on the conditions such as size of the autoclave, but when a medium-sized autoclave of $\phi$200 (diameter) $\times$ 3,000 mm (height) is used, a zinc oxide (ZnO) single crystal of about 3 inches can be easily obtained.

In the case of the crystal grown by the hydrothermal method of the present invention, similarly to the ammonothermal method, the autoclave or when having a gasket or the like or an inlet tube, the inlet tube or the like is not eroded by the solvent and an impurity derived from the autoclave or the like is not introduced into the produced crystal, so that a high-purity crystal can be obtained and the autoclave and the like can be prevented from erosion.

By employing the process in the first or second gist of the present invention, a crystal comprising a nitride of a Periodic Table Group 13 element and having a Cr content of $9\times10^{14}$ cm$^{-3}$ or less and an Fe content of $9\times10^{16}$ cm$^{-3}$ or less (a fourth gist of the present invention) can be obtained. The Cr content in the crystal of the present invention is preferably $5\times10^{14}$ cm$^{-3}$ or less, more preferably $1\times10^{14}$ cm$^{-3}$ or less. The Fe content in the crystal of the present invention is preferably $1\times10^{16}$ cm$^{-3}$ or less, more preferably $3\times10^{15}$ cm$^{-3}$ or less. The Ni content in the crystal of the present invention is preferably $5\times10^{16}$ cm$^{-3}$ or less, more preferably $2\times10^{16}$ cm$^{-3}$ or less, still more preferably $8\times10^{15}$ cm$^{-3}$ or less.

The crystal of the present invention is suitably used for a device, namely, for usage such as light-emitting device and electronic device. Examples of the light-emitting device in which the crystal of the present invention is used include a light-emitting diode, a laser diode, and a light-emitting device combining such a diode with a fluorescent substance. Examples of the electronic device in which the crystal of the present invention is used include a high frequency device and a high-voltage high-power device. Examples of the high frequency device include a transistor (e.g., HEMT, HBT), and examples of the high-voltage high-power device include a thyristor (e.g., IGBT).

The crystal of the present invention is suitable for all of those uses by virtue of its characteristic feature that the impurity concentration is remarkably low. Among these, the crystal of the present invention is suitable particularly for an electronic device required to have a low impurity concentration. In particular, the crystal of the present invention can be suitably used for an electronic device requiring a semi-insulating semiconductor substrate.

By cutting out (slicing) the crystal of the present invention in the desired direction, a semiconductor substrate (wafer) having an arbitrary crystal orientation can be obtained. As a result, a semiconductor substrate having a polar face such as c-plane or a non-polar face such as m-plane or a-plane can be obtained.

EXAMPLES

The characteristic features of the present invention are described in greater detail below by referring to Examples and Comparative Examples. The materials, amounts used, ratios, processing contents, processing procedures and the like described in the following Examples can be appropriately changed or modified without departing from the purport of the present invention. Accordingly, the scope of the present invention should not be construed as being limited to these specific examples.

(Example 1)

Crystal growth of gallium nitride was performed as follows by using polycrystalline h-GaN (hexagonal gallium nitride) as the raw material, using ammonia as the solvent, and adding helium as the substance (X) to the autoclave. Incidentally, the critical densities of ammonia and helium are 0.234 g·cm$^{-3}$ and 0. 0693 g·cm$^{-3}$, respectively, and the difference between these densities is 70.4%.

He was added to the autoclave by using an adding device shown in Fig. 3, and the crystal growth was practiced by using the crystal production apparatus shown in Fig. 1.

Into an Inconel 625-made autoclave (about 40 ml, cross-sectional area: 2 cm$^2$) having an inlet tube with an inlet tube inner volume of 2 ml and being lined with platinum (however, about 3% of the upper part including a cover material, a gasket and the like is not lined with platinum), 1.0 g of polycrystalline h-GaN (hexagonal gallium nitride) as the raw material was charged, and 0.2 g of thoroughly dried NH$_4$Cl was further charged as the mineralizer. After disposing a baffle plate and a crystal growth part such as seed crystal, a cover having mounted thereon a valve was swiftly put on the autoclave, followed by weighing. At the time of disposing the crystal growth part, the top end part of the seed crystal was arranged to come to the position 2 cm lower than the bottom end of the gasket. Subsequently, the inlet tube was operated to communicate with a vacuum pump though the valve attached to the autoclave and after vacuum deaeration by opening the valve, the autoclave was cooled with a dry ice in ethanol solvent while keeping the vacuum state. The valve was once closed and after an operation to allow for communication with an $NH_3$ cylinder, the valve was again opened and $NH_3$ was continuously filled in the autoclave while not contacting with outside air. Based on the flow rate control, $NH_3$ was filled as a liquid corresponding to about 70% of the cavity of the autoclave (calculated in terms of the $NH_3$ density at -33°C). Thereafter, the valve was again closed and after connecting a 100 ml-volume metering syringe having filled therein He of 0.5 MPa, the entire amount of He was filled in the autoclave by the syringe. The valve was closed, the temperature of the autoclave was returned to room temperature, the outer surface was thoroughly dried, and the increment of $NH_3$ was weighed. Incidentally, the amount of He introduced into the inlet tube and the autoclave was 3.8 ml at the critical temperature and critical pressure of He, and this is a volume large enough to satisfactorily cover the inlet tube and the portion not lined with platinum in the upper part of the autoclave.

Subsequently, the autoclave was housed in an electric furnace composed of a heater divided into upper and bottom two parts. The temperature was elevated over 6 hours such that the temperature on the outer surface in the lower part of the autoclave became 530°C, and when the temperature on the outer surface in the lower part of the autoclave reached 530°C, the autoclave was further held at that temperature for 96 hours. The pressure of the autoclave was about 140 MPa. The temperature width during holding was ±10°C or less. Thereafter, the heating by the heater was stopped, and the autoclave was allowed to naturally cool in the electronic furnace. After confirming that the temperature on the outer surface in the lower part of the autoclave dropped nearly to room temperature, the valve attached to the autoclave was opened and $NH_3$ in the autoclave was eliminated. Then, the discharge of $NH_3$ was confirmed by weighing the autoclave, and the valve was once closed. After an operation to allow for communication with the vacuum pump, the valve was again opened and $NH_3$ was almost completely removed from the autoclave. Subsequently, the cover of the autoclave was removed, and the inside was inspected, as a result, about 0.3 g of bulk gallium nitride crystal was precipitated on the seed crystal. Incidentally, precipitation of the crystal and/or mineralizer in the vicinity of the inlet tube was not observed and there was no trouble in the discharge of $NH_3$. Also, since precipitation of the crystal and/or mineralizer in the vicinity of the inlet tube was not observed, it is considered that the solubility of the raw material represented by formula (1) is 0 and the solubility of the mineralizer represented by formula (2) is also 0, and the values corresponding to formulae (1) and (2) both are 20% or less.

The obtained crystal was quantitatively determined by the SIMS (secondary ion mass spectrometry) analysis of Cr, Fe and Ni which are metal components except for Ga detected by a fluorescent X-ray analyzer and heavier than Na. As a result, this crystal could be confirmed to be a hexagonal crystal where Fe is below the detection limit of $3 \times 10^{15}$ $cm^{-3}$, Ni is below the detection limit of $8 \times 10^{15}$ $cm^{-3}$, and Cr is below the detection limit of $5 \times 10^{14}$ $cm^{-3}$. Furthermore, the half-width of the (0002) plane of the obtained crystal was measured by the XRD (X-ray diffraction) method and found to be 753 arcsec.

(Example 2)

Crystal growth of gallium nitride was performed as follows by using polycrystalline h-GaN (hexagonal gallium nitride) and metal Ga as the raw materials and using ammonia as the solvent. Incidentally, during crystal growth, the raw material metal Ga reacts with ammonia to generate hydrogen in the autoclave. The critical densities of ammonia and hydrogen are 0.234 $g \cdot cm^{-3}$ and 0.03102 $g \cdot cm^{-3}$, respectively, and the difference between these densities is 86.7%. Into the same Inconel 625-made autoclave (about 40 ml, cross-sectional area: 2 $cm^2$) as used in Example 1 having an inlet tube with an inlet tube inner volume of 2 ml and being lined with platinum (however, about 3% of the upper part including a cover material, a gasket and the like is not lined with platinum), 1.0 g of polycrystalline h-GaN (hexagonal gallium nitride) as the raw material and 1.0 g of metal Ga were charged, and 0.4 g of thoroughly dried $NH_4Cl$ was further charged as the mineralizer. After disposing a baffle plate and a crystal growth part such as seed crystal, a cover having mounted thereon a valve was swiftly put on the autoclave, followed by weighing. At the time of disposing the crystal growth part, the top end part of the seed crystal was arranged to come to the position 2 cm lower than the bottom end of the gasket. Subsequently, the inlet tube was operated to communicate with a vacuum pump though the valve attached to the autoclave and after vacuum deaeration by opening the valve, the autoclave was cooled with a dry ice in ethanol solvent while keeping the vacuum state. The valve was once closed and after an operation to allow for communication with an $NH_3$ tank, the valve was again opened and $NH_3$ was continuously filled in the autoclave while not contacting with outside air. Based on the flow rate control, $NH_3$ was filled as a liquid corresponding to about 70% of the cavity of the autoclave (calculated in terms of the $NH_3$ density at -33°C). Thereafter, the valve was closed, the temperature of the autoclave was returned to room temperature, the outer surface was thoroughly dried, and the increment of $NH_3$ was weighed.

Subsequently, the autoclave was housed in an electric furnace composed of a heater divided into upper and bottom two parts. The temperature was elevated over 6 hours such that the temperature on the outer surface in the lower part of the autoclave became 530°C, and when the temperature on the outer surface in the lower part of the autoclave reached 530°C, the autoclave was further held at that temperature for 72 hours. The pressure of the autoclave was about 145 MPa. The temperature width during holding was $\pm$10°C or less. Thereafter, the heating by the heater was stopped, and the autoclave was allowed to naturally cool in the electronic furnace. After confirming that the temperature on the outer surface in the lower part of the autoclave dropped nearly to room temperature, the valve attached to the autoclave was opened and $NH_3$ in the autoclave was eliminated. Then, the discharge of $NH_3$ was confirmed by weighing the autoclave, and the valve was once closed. After an operation to allow for communication with the vacuum pump, the valve was again opened and $NH_3$ was almost completely remove from the autoclave. Subsequently, the cover of the autoclave was removed, and the inside was inspected, as a result, about 0.5 g of bulk gallium nitride crystal was precipitated on the seed crystal. Incidentally, precipitation of the crystal and/or mineralizer in the vicinity of the inlet tube was not observed and there was no trouble in the discharge of $NH_3$.

Also, the metal Ga as the raw material was entirely consumed, and the amount of hydrogen generated in the autoclave was 4.6 ml at the critical point of hydrogen. Since the inlet tube inner volume is 2 ml, the inlet tube was sufficiently covered with hydrogen. Furthermore, 2.6 ml of hydrogen was present also in the autoclave and it is considered that the hydrogen was generated in an amount large enough to cover the upper part not lined with platinum. The hydrogen generated in the autoclave is the substance (X) in the following and also comes under the substance (X').

Since precipitation of the crystal and/or mineralizer in the vicinity of the inlet tube after crystal growth was not observed, it is considered that the solubility of the raw material represented by formula (1) is 0 and the solubility of the mineralizer represented by formula (2) is also 0, and the values corresponding to formulae (1) and (2) both are 20% or less. Thus, the hydrogen generated in the autoclave is the substance (X).

The obtained gallium nitride crystal was taken out and measured by the X-ray diffraction, as a result, the crystal form was hexagonal. Furthermore, when elemental analysis of the obtained gallium nitride crystal was performed by the fluorescent X-ray analyzer, EDX700, manufactured by Shimadzu Corporation, only Ga as detected. The metal components except for Ga, which are heavier than Na, were below the detection limit. This reveals that the obtained crystal is a high-purity gallium nitride crystal with less impurities. Also, since the autoclave-derived transition metal component such as Cr, Fe, Ni and Ta is not contained in the obtained crystal, it can be said that the hydrogen generated in the autoclave was substantially not reacted with the autoclave. In addition, because of no precipitation of the mineralizer in the vicinity of the inlet tube, the solubility ratio of the mineralizer represented by formula (3) is considered to be 0, and the value corresponding to formula (3) is 20% or less. Thus, the hydrogen generated in the autoclave is also the substance (X').

The obtained crystal was analyzed in the same manner as in Example 1, as a result, Fe was below the detection limit of $3 \times 10^{16}$ cm$^{-3}$, Ni was below the detection limit of $8 \times 10^{15}$ cm$^{-3}$, Cr was below the detection limit of $5 \times 10^{14}$ cm$^{-3}$, and the half-width of the (0002) plane was 822 arcsec.

(Comparative Example 1)

In order to demonstrate the effect obtained when a substance differing in the critical density from the solvent is allowed to be present, crystal growth was performed by using the same autoclave as used in Examples 1 and 2 through the same procedure as in Examples except that in the system, only a thoroughly dried polycrystalline h-GaN (hexagonal gallium nitride) was used as the raw material and He was not allowed to be present.

Into the lower part of the autoclave, 1.0 g of the raw material (hexagonal gallium nitride) was charged, and 0.2 g of thoroughly dried $NH_4Cl$ was further charged as the mineralizer.

After disposing a structure such as baffle plate, the autoclave was closed and the autoclave was weighed.

Subsequently, a pipeline was connected to the valve attached to the autoclave, and $NH_3$ was filled in the autoclave through the same procedure as in Examples. Based on the flow rate control, $NH_3$ was filled as a liquid corresponding to about 70% of the cavity of the autoclave (calculated in terms of the $NH_3$ density at -33°C). Thereafter, the valve was closed, the autoclave was tightly closed, the temperature of the autoclave was then returned to room temperature, the outer surface was thoroughly dried, and the increment of $NH_3$ was weighed.

The elevation of temperature and the reaction were performed under the same conditions as in Example 2, and then the autoclave was allowed to naturally cool in the furnace. After confirming that the temperature on the outer surface in the lower part of the autoclave dropped nearly to room temperature, the valve attached to the autoclave was opened and in order to confirm the discharge of $NH_3$, the autoclave was weighed. However, the weight was nearly the same as that before elevating the temperature after filling. Therefore, the valve was once closed, the autoclave was cooled with a dry ice in ethanol solvent to almost completely liquefy $NH_3$ in the autoclave, the cover of the autoclave was removed, and $NH_3$ was almost completely removed in a draft. Subsequently, the inside was inspected, as a result, about 0.2 g of bulk gallium nitride crystal was precipitated on the seed crystal. Also, the inlet tube was filled up with white $NH_4Cl$ mineralizer and 0.01 g of needle-like gallium nitride and clogged.

The measurement by the X-ray diffraction revealed that the crystal form was hexagonal, but when elemental analysis was performed by the fluorescent X-ray analyzer, EDX700, manufactured by Shimadzu Corporation, Cr, Fe, Ni and Ta were detected as the metal component except for Ga, which is heavier than Na. In particular, Cr was detected in an amount of about 0.1 wt% in terms of the oxide. Furthermore, the quantitative determination by the SIMS analysis was performed in the same manner as in Example 1, as a result, Fe was $2.5\times10^{17}$ cm$^{-3}$, Ni was $9\times10^{15}$ cm$^{-3}$ and Cr was $4\times10^{15}$ cm$^{-3}$, revealing that the concentrations of Fe and Cr were higher by one figure or more as compared with the crystal obtained in Example 1. In addition, the half-width of the (0002) plane was measured in the same manner as in Example 1 and found to be 2,999 arcsec. Thus, it was confirmed that the half-width is fairly large as compared with the crystal obtained in Example 1.

As seen from these results in Example 1 and Comparative Example 1, according to the process of the present invention, clogging due to precipitation of the crystal and mineralizer on the inlet tube part after the growth is suppressed (Example 1), and the yield is elevated. Also, the obtained nitride crystal (Examples 1 and 2) has higher crystallinity and higher quality with less impurity than the nitride crystal obtained by the process of Comparative Example 1. Furthermore, the gallium nitride crystal obtained by the process of the present invention is very reduced in the mixing of the transition metal component such as Cr, Fe, Ni and Ta and has a high purity.

INDUSTRIAL APPLICABILITY

The nitride compound crystal obtained by the production process of the present invention is assured of less impurity and high crystallinity, reduced in the crystal defect or dislocation density, free from formation of an impurity level, and in the production of various devices such as VPE and MOCVD, usable as a substrate for epitaxial growth. Furthermore, zinc oxide (ZnO) and rock crystal obtained by the hydrothermal method are also assured of less impurity and high crystallinity and therefore usable for various devices in the electronic and optical usage such as surface acoustic wave (SAW) device.

**Claims**

1.  A crystal production process comprising growing a crystal by using a solvent in the supercritical state and/or subcritical state and a raw material in a reaction vessel, wherein
    a substance (X) satisfying the following formula (1) and having a critical density difference of 25% or more from said solvent is allowed to be present in said reaction vessel, and
    the precipitation position of the crystal is controlled by adjusting the amount of said substance (X):

$$\frac{(\text{solubility of raw material in substance (X)})}{(\text{solubility of raw material in solvent})}\times100\leq20 \quad (1)$$

2.  A crystal production process comprising growing a crystal by using a solvent in the supercritical state and/or subcritical state and a raw material in a reaction vessel, wherein
    a substance (X) satisfying the following formula (1) and having a critical density difference of 25% or more from said solvent is allowed to be present in said reaction vessel, and
    the amount of a reaction vessel-derived metal element contained in the grown crystal is controlled by adjusting the amount of said substance (X):

$$\frac{(\text{solubility of raw material in substance (X)})}{(\text{solubility of raw material in solvent})}\times100\leq20 \quad (1)$$

3.  The crystal production process according to claim 1 or 2, wherein the crystal is grown in said reaction vessel by further using a mineralizer satisfying the following formula (2) :

$$\frac{(\text{solubility of mineralizer in substance (X)})}{(\text{solubility of mineralizer in solvent})}\times100\leq20 \quad (2)$$

4.  The crystal production process according to any one of claims 1 to 3, wherein said reaction vessel has an inlet tube at its upper part, the critical density of said substance (X) is smaller than the critical density of said solvent and during the crystal growth, said substance (X) is present in an amount of 1 time or more the volume of said inlet tube.

5. The crystal production process according to any one of claims 1 to 3, wherein said reaction vessel has an inlet tube at its lower part, the critical density of said substance (X) is larger than the critical density of said solvent and during the crystal growth, said substance (X) is present in an amount of 1 time or more the volume of said inlet tube.

6. A crystal production process comprising growing a crystal by using a solvent in the supercritical state and/or subcritical state and a raw material in a reaction vessel with a part of the inner surface being formed of a non-noble metal, wherein a substance (X') having a critical density difference of 25% or more from the solvent and substantially incapable of reacting with the reaction vessel is allowed to be present in the reaction vessel and during the crystal growth, the inner surface portion except for a noble metal is covered with the substance (X').

7. A crystal production process comprising growing a crystal by using a solvent in the supercritical state and/or subcritical state and a raw material in a reaction vessel with a part of the inner surface being formed of a non-noble metal, wherein the amount of a reaction vessel-derived metal element contained in the grown crystal is controlled by adjusting the amount of a substance (X') having a critical density difference of 25% or more from the solvent and substantially incapable of reacting with the reaction vessel in the reaction vessel.

8. The crystal production process as claimed in claim 6 or 7, wherein the crystal is grown in said reaction vessel by further using a mineralizer satisfying the following formula (3) :

$$\frac{\text{(solubility of mineralizer in substance (X'))}}{\text{(solubility of mineralizer in solvent)}} \times 100 \leq 20 \quad (3)$$

9. The crystal production process according to any one of claims 6 to 8, wherein said reaction vessel has an inner surface formed of a non-noble metal at its upper portion and the critical density of said substance (X') is smaller than the critical density of said solvent.

10. The crystal production process according to any one of claims 6 to 8, wherein said reaction vessel has an inner surface formed of a non-noble metal at its lower portion and the critical density of said substance (X') is larger than the critical density of said solvent.

11. The crystal production process according to any one of claims 6 to 8, wherein said reaction vessel has an inlet tube formed of a non-noble metal at its upper part, the critical density of said substance (X') is smaller than the critical density of said solvent, said substance (X') is a substance substantially incapable of reacting with said inlet tube and during the crystal growth, said substance (X') is present in an amount of 1 time or more the volume of said inlet tube.

12. The crystal production process according to any one of claims 6 to 8, wherein said reaction vessel has an inlet tube formed of a non-noble metal at its lower part, the critical density of said substance (X') is larger than the critical density of said solvent, said substance (X') is a substance substantially incapable of reacting with said inlet tube and during the crystal growth, said substance (X') is present in an amount of 1 time or more the volume of said inlet tube.

13. The crystal production process according to any one of claims 1 to 12, wherein said substance (X) or said substance (X') is added to said reaction vessel.

14. The crystal production process according to any one of claims 1 to 13, wherein said substance (X) or said substance (X') is selected from the group consisting of hydrogen, helium, nitrogen, chlorine and oxygen.

15. The crystal production process according to any one of claims 1 to 14, wherein the obtained crystal is a single crystal.

16. The crystal production process according to any one of claims 1 to 15, wherein the obtained crystal is any one of a nitride of a Periodic Table Group 13 element, ZnO and rock crystal.

**17.** The crystal production process according to any one of claims 1 to 16, wherein said solvent is a nitrogen-containing solvent.

**18.** The crystal production process according to any one of claims 1 to 17, wherein said solvent is water.

**19.** The crystal production process according to any one of claims 4, 9 and 11, wherein said solvent is a nitrogen-containing solvent and said substance (X) or said substance (X') is hydrogen and/or helium.

**20.** The crystal production process according to any one of claims 5, 10 and 12, wherein said solvent is a nitrogen-containing solvent and said substance (X) or said substance (X') is nitrogen and/or chlorine.

**21.** The crystal production process according to any one of claims 4, 9 and 11, wherein said solvent is water and said substance (X) or said substance (X') is hydrogen and/or helium.

**22.** The crystal production process according to any one of claims 5, 10 and 12, wherein said solvent is water and said substance (X) or said substance (X') is oxygen.

**23.** The crystal production process according to claim 3 or 8, wherein said mineralizer is an acidic mineralizer.

**24.** The crystal production process according to any one of claims 1 to 23, wherein said reaction vessel is an autoclave.

**25.** A crystal production apparatus using a solvent in the supercritical state and/or subcritical state, the apparatus comprising a metering mechanism for adding a substance differing in the critical density from said solvent at a predetermined ratio to a reaction vessel.

**26.** The crystal production apparatus as claimed in claim 25, wherein the reaction vessel is an autoclave.

**27.** A crystal comprising a nitride of a Periodic Table Group 13 element, produced by a crystal production process of growing a crystal by using a solvent in the supercritical state and/or subcritical state and a raw material in a reaction vessel, wherein the Cr content is $9 \times 10^{14}$ cm$^{-3}$ or less and the Fe content is $9 \times 10^{16}$ cm$^{-3}$ or less.

**28.** The crystal as claimed in claim 27, wherein the Ni content is $5 \times 10^{16}$ cm$^{-3}$ or less.

**29.** The crystal as claimed in claim 27 or 28, wherein said nitride of a Periodic Table Group 13 element is gallium nitride.

**30.** A device using the crystal claimed in claim 29.

Fig.1

Fig.2

Fig.3

Fig.4

Fig.5

Fig.6

<div style="text-align:center">

**INTERNATIONAL SEARCH REPORT**

</div>

| | International application No. |
|---|---|
| | PCT/JP2006/312956 |

A. CLASSIFICATION OF SUBJECT MATTER
*C30B7/10*(2006.01)i, *C30B29/16*(2006.01)i, *C30B29/18*(2006.01)i, *C30B29/38* (2006.01)i

According to International Patent Classification (IPC) or to both national classification and IPC

B. FIELDS SEARCHED

Minimum documentation searched (classification system followed by classification symbols)
C30B7/10, C30B29/16, C30B29/18, C30B29/38

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)
CA(STN), JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| P,A | JP 2005-289797 A (Mitsubishi Chemical Corp.), 20 October, 2005 (20.10.05), Claims; Par. No. [0033] (Family: none) | 1-30 |
| A | YOSHIKAWA A. et al., Crystal growth of GaN by ammonothermal method, Journal of Crystal Growth, Vol.260, 2004, pp. 67-72 | 1-30 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 September, 2006 (20.09.06) | 03 October, 2006 (03.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004315361 A
- JP 2004002152 A
- JP 2003165794 A
- JP 2005066543 A

**Non-patent literature cited in the description**

- **CHEN et al.** *J. Crystal Growth,* 2000, vol. 209, 208